# EUROPEAN PATENT APPLICATION

(11) **EP 1 149 933 A1**
(43) Date of publication of application: **31.10.2001**
(21) Application number: 00830319.0
(22) Date of filing: 28.04.2000
(51) Int. Cl.: C23C 16/30, C09D 4/00, H01L 21/768, H01L 21/312

(54) **Deposition method of dielectric films having a low dielectric constant**

(71) Applicant: STMicroelectronics S.r.l., 20041 Agrate Brianza (Milano) (IT)
(72) Inventor: Vulpio, Michele, 70050 Santo Spirito (BA) (IT)
(74) Representative: Botti, Mario

(57) **Abstract**

The present invention relates to a method of low-dielectric-constant film deposition on a surface of a substrate of semiconductor material. Such deposition can be obtained through CVD (Chemical Vapour Deposition) techniques which provide for the use of a wide class of precursor monomeric compounds, which are typically known as organosilanes.

## Description

### Field of application

The present invention relates to a method of low-dielectric-constant film deposition on semiconductor through CVD (Chemical Vapour Deposition) techniques, usable for manufacturing integrated electronic circuits with VLSI (Very Large Scale Integration) modes.

### Prior Art

As it is known, low-dielectric-constant films are very important materials in the field of insulation technology currently used for manufacturing VLSI electronic circuits. At present, silicon oxide is the dielectric most used in the microelectronics industry. On the other hand, microelectronics industry tends to carry out a continuous shrinking of the devices in HC-MOS technology, thus reducing the avarage distances between the various devices and in particular, between the single active elements of the devices. Thus, there is an increasingly felt need of creating low-dielectric-constant films so as to reduce the thickness of the insulation dielectric but, more in particular, so as to reduce the effects of the stray capacity which set up among the various electrically active structures because of the interposed dielectric. Hence the constant search for materials functioning as insulation dielectrics and having increasingly better gap-fill and step-coverage capacities.

The following deposition methods are known in literature (T. Shirafuji et al., Plasma Copolymerization of Tetrafluoroethylene/Hexamethyldisiloxane, and in situ Fourier Transform Infrared Spectroscopy of Its Gas Phase, Jpn. J. Appl. Phys., Vol. 38, No. 7 B, 1999, pp. 4520-4526;
S. M. Yun et al., Low-Dielectric-Constant-Film Deposition with Various Gases in a Helicon Plasma Reactor, J. Appl. Phys., Vol. 38, No. 7 B, 1999, pp. 4531-4534;

Y. C. Quan et al., Polymer-like Organic Thin Film deposited by Plasma Enhanced Chemical Vapour Deposition, Using the Para-xylene Precursor as Low Dielectric Constant Interlayer Dielectrics for Multilevel Metallization, J. Appl. Phys., Vol. 38, No. 3A, 1999, pp. 1356-1358; L. M. Han et al., Pulsed plasma polymerization of pentafluorostyrene: Synthesis of low dielectric constant films, J. Of Appl. Phys., Vol. 84, No. 1, 1998, pp. 439-444;

S. M. Yun et al., SiOF Film Deposition Using FS(OC₂H₅)₃, J. Of Electrochem. Soc., Vol. 1.45, No. 7, 1998, pp. 2576-2580;

V. Pankov et al., The Effect of Hydrogen Addition on the Fluorine Doping Level of SiOF Films Prepared by Remote Plasma Enhanced Chemical Vapor Deposition Using SiF₄-based Plasmas, Jpn. J. Appl. Phys., Vol. 37, No. 11, 1998, pp. 6135-6141; Y. Uchida et al., A Fluorinated Organic-Silica Film with Extremely Low Dielectric Constant, Jpn. J. Appl. Phys., Vol. 38, No. 4B, 1999, pp. 2368-2372).

These currently used methods are known for the deposition of low-dielectric-constant films through CVD methods, such as SACVD (Sub Atmospheric Chemical Vapour Deposition), PECVD (Plasma Enhanced Chemical Vapour Deposition), LPCVD (Low Pressure Chemical Vapour Deposition), APCVD (Atmospheric Pressure Chemical Vapour Deposition) and HDP-CVD (High Density Plasma Chemical Vapour Deposition). Chemical compounds, called precursors, are used for starting the film deposition process, which must consist of chemical elements that will form the chemical structure of the final film.

The current low-dielectric-constant films are fluorocarbons deposited by plasma; fluorine enhanced silicon oxides, SiOF, obtained from mixtures of HMDSO (hexamethyldisiloxane) and TFE (tetrafluoroethylene), P-XILENE (para-xylene) and pentafluorostyrene deposited by plasma-chemical methods or by FTES (fluoro-triethylsesquioxane) through CVD or FSG (Fluoro Silicon Glass) methods deposited through HDP-CVD by a mixture of tetrafluofluorosilane and silane; "diamond-like" films obtained either by high-temperature processes or with plasma techniques from hydrocarbon mixtures; HSQ (sesquioxide) and MSQ (methylsesquioxane) deposited through a "spin-coating" process.

Nevertheless, the above-described methods described above exhibit significant disadvantages and limits.

In fact, by using plasma-chemical techniques, it is not possible to control the stoichiometry of the produced film, which among the other things exhibits limited "gap fill" and "step coverage". On the contrary, the problem of SiOF films is the fluorine dissipation during the heating step. As regards to fluorocarbons, a big and unsolved problem is the low thermal stability because of which these films could decompose, after heating, thus freeing fluorine ions which would irreversibly impair the operation of the device.

Another problem of the loco k film deposition is the throughput of the films currently implementable in plasma-chemical industrial processes. A solution to such problem has been proposed in the U.S. Patent No. 4,938,995 (granted on 3rd July 1990 to Giordano et al., and assigned to The Standard Oil Company). Films deposited in reasonable process times through "spin-coating" are described in the U.S. Patent No. 5,889,104 (granted on 30th May 1999 to Rosenmayer and assigned to W. L. Gore & Associates, Inc.).

Moreover, these films have a low dielectric constant and thermal stability above 400 °C. Nevertheless, the films deposited through "spin-coating" can deteriorate because of the treatments during the plasma phase to which the device is subjected during the machining steps subsequent to the deposition, and because of the properties of these films, which behave as insulators and interact with oxygen (O₂). But above all, the high porosity of these films causes a low dielectric constant, and makes them unreliable for use in a process flow for manufacturing microelectronics devices. Moreover, a big disadvantage of poly-organic films is that they have a low resistance to thermal treatments.

Thus, in the microelectronics industry there is the need of using deposition precursor compounds so as to obtain low-dielectric-constant films which are technically advantageous for manufacturing VLSI electronic circuits.

The technical problem at the basis of the present invention is that of devising a method of low-dielectric-constant-film deposition by using the conventional CVD techniques used in the coating processes of thin films, and a more advantageous class of precursor compounds from the thermal stability point of view, of the evenness of the produced film and of the process conditions.

### Summary of the invention

The idea at the basis of the present invention is that of using a class of monomeric compounds, called organosilanes, as deposition precursors in the conventional CVD techniques which are suitable for the industrialisation of thin film coating processes.

Essentially, according to the invention, the method comprises the use of a class of silicon compounds bound to oxygen and to an organic portion as deposition precursors, called organosilanes.

On the basis of said resolutive idea, the technical problem is solved by a method of low-dielectric-constant film deposition on a surface of a substrate of semiconductor material, through CVD (Chemical Vapour Deposition) techniques which provide for the use of a class of precursor monomeric compounds, consisting of oxygenated organosilanes. Said precursor monomers contain at least one silicon-oxygen-organic unit bond. Said organic unit preferably is a non-substituted benzene ring or having at least one substituent selected from the group comprising C₁₋₄ alkyl, halogen, CF₃ or other aromatic compounds. Advantageously, according to the invention, these monomeric compounds have the following formula: 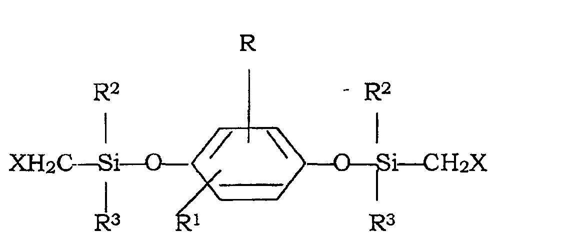 wherein R and R¹ are independently equal to H, Hal, C₁₋₄ alkyl, CF₃, C₁₋₄ alkoxide, NO₂, optionally substituted aromatic ring; R² and R³ independently are C₁₋₄ alkyl and X is halogen, in particular Br or Cl.

The features and the advantages of the method according to the invention will appear from the following description of an embodiment thereof, made as a non-limitative indication.

### Detailed description

The process steps and the structures described hereinbelow do not form a complete process flow for manufacturing integrated circuits. In fact, the present invention can be implemented together with the manufacturing techniques of integrated circuits currently used in the field, and only those process steps that are commonly used and are necessary for understanding the invention are hereafter described.

The proposed method allows to carry out a low-dielectric-constant film deposition step using monomers containing the Si-O-Ar-O group, that is, containing a silicon-oxygen bond bound to an aromatic ring. For example, one of said compounds consists of 1,4-bis-[chloromethyl]dimethyl-silil-oxybenzene. The main feature of these compounds consists in the silicon-oxygen-benzene bond. In fact, as it is known in literature, the Si-O bond exhibits the feature of thermally stabilising the deposited film, and the organic unit allows to obtain a low-dielectric-constant film, made of a basic unit, which is repeated in the three space directions which form the entire film stack, wherein organic compounds based on C, H, O are present. Moreover, the fact that in this case the organic unit consists of a benzene ring also allows to obtain films with a high thermal and chemical stability. Moreover, the benzene ring can have one or more substituents. In particular, by substituting the benzene ring with halogens, such as fluorine and chlorine, it is possible to obtain a further reduction of the dielectric constant.

It is important to point out that these compounds are produced at a high purity (99%), and their chemical and physical features are suitable for their use as precursors in the CVD techniques. In particular, the boiling point of the compound mentioned by way of example is 118 °C, that is to say, it is lower than that of TEOS (tetraethylorthosilicate), which is the liquid currently used for silicon-oxide film deposition. This particular feature allows to obtain a process flow during which the monomer is stable. A possible process flow is that wherein SACVD is used as CVD sample technique for dielectric deposition. Hereinafter it is shown the typical SACVD process, activated by ozone, in the case 1,4-bis-[chloromethyl]dimethyl-silyl-oxybenzene is used:

C₆H₄[OSi(CH₃)₂CH₂Cl]2+13O₂ -> 6CO₂ + 14H₂O + [Si-O-C₆H₄-O-Si]2HCl

The obtained films, according to the invention, exhibit all the most important features of low-dielectric-constant films:
- dielectric constant lower than that of silicon oxide, which is equal to 3.9;
- thermal stability above 400 °C, when films are used as PMD (Pre Metal Dielectric) and IMD (Inter Metal Dielectric) layers;
- better "gap fill" and "step coverage" and suitable to the advanced technologies (<0.18µ);
- chemical inertia during the other processes to which the devices are subjected. In fact, the low dielectric constant is guaranteed by the organic portion contained in the film; the high thermal stability is due to the Si-O bond and to the organic unit, characteristic of organosilanes; moreover, the organic unit reduces the chemical reactivity of the film.

Thus, the films obtained according to the invention exhibit good electric and chemical-physical properties. Moreover, by using the same deposition precursor and by changing the CVD technique (SACVD, LPCVD, APCVD, PECVD) it is possible to obtain different types of films, which differ for example in chemical-physical parameters, density, chemical composition, dielectric constant, film stress, resistance to temperature. Finally, the films deposited using the precursor class herein proposed can be advantageously used as PMD (Pre Metal Dielectric) and IMD (Inter Metal Dielectric) and they are thus easily usable on industry scale.

## Claims

1. Deposition of dielectric films having a low dielectric constant on a surface of a semiconductor material substrate, through CVD (Chemical Vapour Deposition) techniques which provide for the use of a class of precursor compounds, **characterised in that** said precursor compounds are oxygenated organosilanes.

2. Method according to claim 1, **characterised in that** said organosilanes comprise at least a silicon-oxygen-organic unit bond.

3. Method according to claim 2, **characterised in that** said organic unit is an optionally substituted benzene ring.

4. Method according to claim 3, **characterised in that** said benzene ring bears at least a substituent selected in the group comprising C₁₋₄ alkyl, halogen, CF₃, H, aromatic ring in turn substituted.

5. Method according to claim 3, **characterised in that** said monomeric compounds have the following formula: 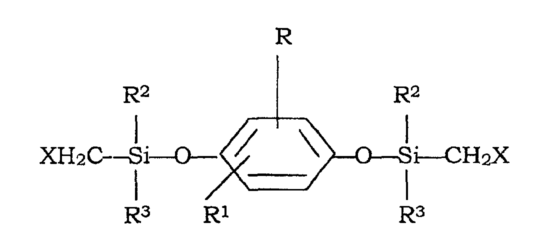 wherein R and R¹ are independently equal to H, Hal, C₁₋₄ alkyl, CF₃, C₁₋₄ alkoxide, NO₂, aromatic ring; R² and R³ independently are C₁₋₄ alkyl and X is halogen, in particular Cl or Br.

6. Method according to claim 5, **characterised in that** R and R¹=H, R² and R³=CH₃ and X=Cl.

7. Low-dielectric-constant film deposited on a surface of a substrate made of semiconductor material, through CVD (Chemical Vapor Deposition) deposition techniques, that provide for the use of a class of monomeric precursor compounds, **characterised in that** it has a polymeric structure containing monomeric units 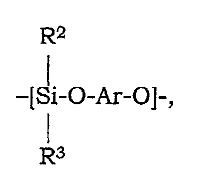 wherein Ar is an optionally substituted benzene ring and R² and R³ are independently C₁₋₄ alkyl, (optionally substituted) aromatic ring in place of the O-Ar bond.

8. Low-dielectric-constant film according to claim 7, **characterised in that** said benzene ring is not substituted or is substituted by at least one substituent selected in the group comprising Hal, C₁₋₄ alkyl, CF₃, C₁₋₄ alkoxy, NO₂, H, optionally substituted aromatic ring.

9. Low-dielectric-constant film according to claim 8, **characterised in that** R² and R³ are CH₃.

10. Low-dielectric-constant film according to claim 9, **characterised in that** said benzene ring is not substituted.
